# EUROPEAN PATENT SPECIFICATION

(11) **EP 2 775 351 B1**
(45) Date of publication and mention of the grant of the patent: **22.02.2017**
(21) Application number: 13158173.8
(22) Date of filing: 07.03.2013
(51) Int. Cl.: G03F 7/30

(54) **Apparatus and method for processing a lithographic printing plate**
Vorrichtung und Verfahren zur Verarbeitung einer Lithografiedruckplatte
Appareil et procédé de traitement d'une plaque d'impression lithographique

(43) Date of publication of application: 10.09.2014
(73) Proprietor: Agfa Graphics NV, 2640 Mortsel (BE)
(72) Inventor: Desmet, Tim, 2640 Mortsel (BE); Moriamé, Philippe, 2640 Mortsel (BE); Hendrikx, Peter, 2640 Mortsel (BE); Sinnesael, Jan, 2640 Mortsel (BE)

(56) References cited:
- EP-A2- 0 583 032
- WO-A2-2004/106084
- WO-A2-2004/108413
- WO-A2-2008/054638
- US-B1- 6 302 600

## Description

### FIELD OF THE INVENTION

The present invention relates to an apparatus and a method for developing lithographic printing plates with a reduced consumption of developer.

### BACKGROUND OF THE INVENTION

Lithographic printing typically involves the use of a so-called printing master such as a printing plate which is mounted on a cylinder of a rotary printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Lithographic printing masters are generally obtained by the image-wise exposure and processing of an imaging material called plate precursor which contains a heat- or light-sensitive coating on a substrate. The coating of the precursor is exposed image-wise to heat or light, typically by means of a digitally modulated exposure device such as a laser, which triggers a (physico-)chemical process, such as ablation, polymerization, insolubilization by cross-linking of a polymer or by particle coagulation of a thermoplastic polymer latex, solubilization by the destruction of intermolecular interactions or by increasing the penetrability of a development barrier layer. Although some plate precursors are capable of producing a lithographic image immediately after exposure, the most popular plate precursors require wet processing with a developer since the exposure produces a difference of solubility or of rate of dissolution in a developer between the exposed and the non-exposed areas of the coating. In positive working plates, the exposed areas of the coating dissolve in the developer while the non-exposed areas remain resistant to the developer. In negative working plates, the non-exposed areas of the coating dissolve in the developer while the exposed areas remain resistant to the developer. Most plates contain a hydrophobic coating on a hydrophilic substrate, so that the areas which remain resistant to the developer define the ink-accepting, printing areas of the plate while the hydrophilic substrate is revealed by the dissolution of the coating in the developer at the non-printing areas.

Conventionally, a plate is developed by immersion in the developer as it passes through the processing apparatus. Typically the plate is also subjected to mechanical rubbing with e.g. a rotating brush while or after being immersed in the developer. After development, the plate is typically rinsed with water to remove any remaining developer and then gummed, which may also be called finished or desensitized. Gumming involves the application of a protective coating on the lithographic image, especially the non-printing areas to avoid contamination or oxidation of the aluminum substrate. Gum can be applied by immersion, by spraying or by jetting as disclosed in EP1524113A.

An important trend in lithographic platemaking is related to ecology and sustainability. Systems and methods which enable a low consumption of developer or which allow processing with aqueous developers comprising no hazardous chemicals and/or which have a pH close to 7 (neutral developer), have attracted a lot of attention in the marketplace. A convenient method which has become popular involves the use of a gum solution as developer, whereby the plate is developed and gummed in a single step as described in e.g. EP1342568A and WO2005/111727. Such methods however can only be used for specially designed plates, which have lithographic coatings that are sufficiently soluble or dispersible in the gum solution so that a good clean-out (complete removal of the coating at non-printing areas) is obtained.

Other so-called 'chemistry-free' processing methods involve the use of the printing press as processing apparatus : the exposed plate is mounted on the plate cylinder of the press and the lithographic image is then developed by means of the ink and/or fountain which is supplied to the plate during the first revolutions of the printing press as disclosed in e.g. EP770494A and WO2002/21215. Such methods also require specially designed plate coatings and may produce additional problems such as contamination of the fountain by the coating which is removed at non-printing areas, lack of daylight stability in the time between the exposure of the plate and the on-press development or the lack of a visible image (which allows quality control of the plate) before the plate is mounted on the press.

WO2004/106084 relates to the application of a thin film of developer solution on the surface of a printing plate precursor in a controlled way by using a wire-wound coating device.

EP 583 032 discloses an apparatus for developing an exposed printing plate precursor including means for calculating the surface area of the plate precursor.

US 6,302,600 discloses an apparatus for treating the surface of boards with a treating fluid including a treating means, a solution collecting means, a storing means for waste, a detection means for measurement of the concentration of ingredients in the fluid, a supplementing means for adding ingredients to the fluid and a feeding means for feeding the adjusted fluids to the treating means.

Systems wherein developer is applied on the plate by spray bars or other arrays of nozzles such as inkjet orifices are described in e.g. EP1521123A, EP127150A, WO2012064686, WO2008054638, US20050768021, US2005/0162505, US2008/0101792 and US2009/0197206. In such development methods and equipment the developer is applied by a coating head on the plate as a liquid film, rather than by immersion of the plate in the developer liquid. Such methods allow to reduce the amount of developer that is necessary for the development and provide the additional advantage that only fresh developer, which is not contaminated by previously processed plates, can be applied. However, the amount of developer liquid applied is not related to the size of the plate and neither to the image content of the plate, so that still too much developer is applied than really necessary for the development.

WO2004/108413 discloses an apparatus for developing a printing plate including a control means for (i) activating a printhead to jet developer solution onto the surface of the plate and for (ii) deactivating the printhead in response to the absence of the plate.

US2008/0305263 discloses a method for gumming a developed printing plate, wherein the non-printing areas of the plate are detected optically, e.g. by detection of a color difference with the printing areas, and gum is applied on the non-printing areas only with an inkjet head in accordance with the detected location of those areas. Such method however is not suitable for the development of a plate since a non-developed plate does not contain printing and non-printing areas which can be detected optically.

As a result, it remains difficult to provide environment-friendly processing systems which consume a low amount of developer.

### SUMMARY OF THE INVENTION

It is therefore an object of the present invention to provide a plate processing apparatus and a method of developing a plate which enable to reduce the consumption of developer liquid. It is an object of preferred embodiments to reduce also the consumption of gum solution which may be applied on the developed plate in order to protect the lithographic image.

These objects are realised by the apparatus and the method defined in the appending claims. The present invention allows to apply developer only on the non-printing areas of the plate where the image-recording coating of the plate needs to be removed from the substrate. More preferably, the present invention allows to apply developer liquid in a controlled way so that the amount of developer applied to each section of the image is dependent on the average dot coverage of that section of the image.

Although the invention provides particular advantages for developing positive working plates, the reduction of chemistry consumption is achieved also when developing negative working plates.

### DETAILED DESCRIPTION OF THE INVENTION

The apparatus of the present invention comprises plate detection means for locating the plate in the apparatus and for determining the plate width, which is defined by the edges of the plate. Such plate detection means may include one or more switches which are actuated by the weight of the plate as it passes through the apparatus, or by optical or other mechanical means for detecting the width and location of the plate, or combinations thereof. The plate detection means may also include a mechanical device for pushing one of the plate edges against a guide bar, combined with means for detecting the edge of the plate opposite to said guide bar. The plate detection means includes electronic means for retrieving the plate area and/or the plate size from the plate setter or from the prepress workflow system which has been used for the exposure of the plate to be processed.

The information about the location of the plate and the plate area may be supplied to a controller which allows the selective deposition of developer on the plate by actuating one or more nozzles N1. In the embodiment using only a single nozzle N1, the latter is mounted to shuttle across the width of the plate so that developer can be deposited over the whole plate area by the single nozzle. The shuttle may also contain more than one nozzles N1, e.g. two, three, four, five or more nozzles N1 are configured to shuttle together across the plate. In a shuttle comprising more than one nozzle N1, the nozzles N1 are preferably arranged in a spaced-appart array which is parallel to the path along which the plate is conveyed through the apparatus and the shuttling movement preferably occurs perpendicular to said path. The nozzle configuration of the shuttle may also be configured otherwise, e.g. as an array which is arranged at an angle, e.g. 45°, with respect to the path of the plate.

Alternatively, the nozzles N1 can be arranged in a fixed array which spans at least the width of the plate. The array preferably comprises nozzles N1 which are spaced apart along the width of the plate, i.e. along the direction which is perpendicular to the path along which the plate is conveyed through the apparatus, but other configurations are also possible, such as an array which is arranged at an angle of less than 90°, e.g. 45°, with respect to the path of the plate.

The nozzles N1 can be arranged in an array, fixed or shuttling, along a straight line or otherwise, e.g. in a staggered (zig-zag) or a matrix configuration.

"Selective deposition" as used herein means that the nozzle(s) N1 is (are) actuated selectively, i.e. in such a way that developer is deposited on the plate area, without substantially depositing developer outside the area of the plate. Especially in embodiments wherein an array having a low nozzle resolution (number of adressable nozzles N1 per unit of area, or per unit of length in embodiments with a linear array) is used, such as a spray bar, it is preferred that the area on which the nozzles N1 apply the developer, is slightly larger, e.g. 1 to 10% larger, than the plate area so that sufficient developer is applied over the whole area of the plate, however without depositing a substantial amount of unnecessary developer outside the plate area.

In the art, selective deposition is achieved without an intelligent controller, by a direct connection between the above mentioned mechanical switches or optical plate detectors and the nozzle(s) N1, preferably with a time delay mechanism or circuit, so that no developer is deposited in the time during which the leading edge of the plate travels from the detector(s) to the nozzle(s) N1. Sophisticated embodiments **of the invention** comprise a controller,preferably a unit comprising logic or digital circuits which enable to actuate the nozzle(s) N1 selectively.

The controlled deposition of developer is achieved in accordance with the image data that have been used to expose the plate, e.g. by means of a platesetter such as a laser recorder. A lithographic image is a so-called halftone image consisting of ink-accepting dots which are surrounded by non-printing areas, wherein the size and/or the frequency of the dots is proportional to the tone value of the image. Different screening methods are available which convert a continuous tone image into a halftone image and the dot size depends on the screening method used. The so-called frequency-modulated screening methods produce dots of a very small size, e.g. 10x10 µm. Other methods such as amplitude-modulated screening methods produce larger dots which may even be visible to the naked eye. Hybrid screening methods produce a halftone image which has features of both frequency-modulated and amplitude-modulated images. All these methods convert a continuous tone image into an image consisting of discrete printing dots wherein the dot coverage of a section of the image is dependent on the tone value of that section of the image. A full black section of an image has a 100% dot coverage and consists entirely of a single printing area, formed by adjacent or even overlapping dots.

In a preferred embodiment of the present invention which allows the controlled deposition of developer in accordance with the image data, the apparatus further comprises means for providing input of dot coverage image data of the plate from the platesetter or the pre-press workflow system, which has been used for the exposure of the plate, to the controller. According to the present invention, the controller comprises means for adjusting the amount of developer deposited by the nozzles(s) N1 on a section of the image, wherein said amount of developer deposited by each nozzle is dependent on the average dot coverage of that section. This allows a further reduction of developer consumption since developer is deposited only or mainly on areas of the coating which need to be removed from the substrate (the non-printing areas), while minimizing the deposition of developer on the other areas (the printing areas), preferably even without a substantial deposition of developer on the printing areas.

The selective deposition of developer is achieved preferably by the ejection of droplets, a jet or a spray of developer liquid from the nozzles N1. Suitable examples of such nozzles include spray nozzles, inkjet nozzles, valve-jet nozzles or needles. An array or nozzles N1 may also comprise combinations thereof.

The nozzle(s) N1 may be configured to deposit either a fixed volume of developer or no developer at all (on-off mode) or may deposit an adjustable volume of developer, preferably in accordance with the image data. Volume-metered deposition of developer in accordance with the image data can also be achieved by ejecting a plurality of drops of developer liquid, wherein each drop has an essentially constant volume. By using a nozzle N1 array of high resolution, such as an inkjet head, for depositing developer, it is possible to deposit developer liquid only on the non-printing areas without substantially wetting the printing dots with developer. However, such high-resolution arrays are expensive and may be susceptible to nozzle clogging or other defects which require a complex cleaning mechanisms or other maintenance systems. Therefore, it is more preferred to use one or more nozzle(s) N1 of lower resolution, which each deposit developer on the plate over a section of the image that is larger than the printing dots, e.g. a section of 1 cm². In such embodiment, the amount of developer can be controlled in accordance with the tone value, preferably the average dot coverage, of the image section which is affected by each nozzle N1, so that an image section comprising many large dots is provided with a smaller amount of developer than an image section which comprises mainly small dots.

The apparatus may also contain means for mechanically rubbing or brushing the plate after the developer has been applied, e.g. by means of one or more rotating brushes, although this is often not necessary for positive plates, especially when the impact of developer is sufficient to dislodge partially dissolved coating material from the substrate.

The best performing embodiments of the present invention enable to obtain a significant reduction of developer consumption compared to prior art methods. Good clean-out was obtained with an amount of less than 50 ml/m², and for most plates 30 to 40 ml/m² is sufficient. The developer can be prepared, preferably inside the apparatus, by diluting concentrated developer with water, e.g. between 5 and 10 times. A preferred embodiment allows to develop plates with good clean-out by using less than 6 ml/m², preferably from 4 to 6 ml/m², of concentrated developer, which may be diluted e.g. 8x with water.

In a preferred embodiment, the apparatus of the present invention also comprises means for applying a gum solution to the developed plate. Gumming can be achieved by immersing the developed plate in a gum solution, or by spraying or coating of a gum solution onto the developed plate. Preferably, the apparatus of the present invention further comprises one or more nozzle(s) N2 for depositing a gum solution on the plate area. The nozzle(s) N2 has (have) preferably the same features as described above in relation to the nozzle(s) N1. Accordingly, the nozzle(s) N2 can also be arranged as a shuttle or a fixed array. The arrangement of nozzles N1 and N2 may be the same or different.

Preferably, the nozzle(s) N2 can also be controlled in accordance with the plate area and/or the image data of the plate in the same way as described above in relation to nozzle(s) N1. Nozzle(s) N1 and N2 can be controlled each by a separate controller or they can both be controlled by the same controller. Accordingly, the controller may comprise means for actuating nozzles N2 which are positioned to deposit gum solution on non-printing areas of the image, preferably without substantially actuating nozzles N2 which are positioned to deposit gum solution on the printing areas of the image. Alternatively, the nozzles N2 which are positioned to deposit gum solution on the printing areas are also actuated, but to a lesser extent so that the amount of gum applied on the printing areas is lower than on the non-printing areas. As a result, also the consumption of gum solution can be significantly reduced.

In another embodiment of the present invention, a gum solution is used as developer, which is applied to the plate by means of nozzle(s) N1. In such configuration, nozzles (N2), if present, may also be used to apply a second gum solution, e.g. a gum solution which is less aggressive towards the coating of the plate than the gum deposited as developer by nozzle(s) N1; in such embodiment, the second gum solution may have a pH closer to neutral or may contain less organic solvents or surfactants than the first gum solution. Said second gum solution then mainly serves as a preservation gum which prevents dot loss that could occurr when the first gum solution would remain on the plate.

The apparatus of the present invention may further comprise one or more rinse sections, e.g. between the development section and the gum section, wherein the plate is immersed in water, or coated, sprayed or flooded with water or a combination thereof. After the final gum has been applied, the plate is preferably not rinsed but immediately conveyed to the drying section of the apparatus. Drying can be achieved by hot air, infrared radiation, and other methods generally known in the art.

### DETAILED DESCRIPTION OF PREFERRED EMBODIMENTS

### Brief description of the drawings

FIG. 1 is a schematic elevation view of one embodiment of the apparatus of the invention, having an array of spray nozzles N1 for depositing developer onto the plate.
FIG. 2 a schematic representation of the continuously moving target area of spray impingement.
FIG. 3 is a schematic view of the spray bar and spray pattern, as seen from the right of FIG. 1.

### Apparatus

Excellent development can be obtained by depositing the developer onto the non-printing areas of the image recording coating of the plate with a turbulent flow of fresh developer liquid. At sufficient volumetric flow rate, the developer liquid is constantly displaced at the plate surface during the local development dwell time, whereby no boundary layer forms on and travels with the plate during the development time and thus the target area of the nozzle(s) N1 is always in contact with fresh developer liquid. Development proceeds without a developer strength gradient from the coating surface to the substrate. As a consequence, the plate experiences no localized depletion of developer strength and is developed rapidly and uniformly.

Developer overflow may be collected in a sump and/or drained in a storage tank without recirculation back to the nozzle(s) N1. Alternatively, the developer overflow can be collected and recirculated, which is preferably combined with the addition of a replenishment solution to compensate for drag out and any other diminution of recycled developer effectiveness and to reduce the risk of clogging of the nozzles N1.

In one embodiment of the present invention, an imaged plate is developed using a pressurized spray to apply the developer. The spray is preferably applied by a single spray bar of nozzles N1 with overlapping nozzle flow. Spray nozzles are commercially available in thousands of sizes and configurations, e.g. from Spraying Systems Co. (Wheaton, Illinois, USA). Important parameters of the spray nozzles are the flow rate, the spray pressure, the drop size, the spray pattern and the spray nozzle alignment. Useful spray pressures are in the range of 1 to 5 bar, more preferably from 1.5 to 2.5 bar. At high spray pressure, the development can be enhanced by the mechanical force of the impinging spray. A preferred spray pattern is a tapered-edge flat pattern because it can provide a uniform coverage over the entire plate area as a result of overlapping distributions. The angle of the spray cone and the spray distance between the spray nozzle N1 and the plate define the target area on the plate. The nozzles N1 used in the present invention may have a spray angle from 5° to 170°, the larger angle producing a large target area for a given spray distance. The nozzle target area on the plate depends on the spray angle and the spray distance and may be up to 15 cm, which can be achieved by a nozzle N1 having e.g. a spray angle of 110° and a spray distance of 5 cm. However a smaller target area is preferred, e.g. less than 5 cm which may be achieved by a nozzle N1 with a spray angle of 50° and a 5 cm spray distance or 30° and 10 cm respectively. Suitable drop sizes of the spray are from less than 1 mm, e.g. 100 µm (achieved by so-called atomizing nozzles), up to a few mm, e.g. from 1 to 5 mm, preferably from 1 to 2 mm. The drop size is mainly determined by the spray pressure and of course the properties of the developer liquid.

The spray nozzles N1 are preferably made of a material which is resistant to the developer liquid and provides a long wear life, e.g. stainless steel, a ceramic or a carbide. More information about spray nozzles can be found in e.g. the books "Industrial Sprays and Atomization", Springer, 1st edition (September 17, 2002) and "Handbook of Atomization and Sprays", Springer, 2011.

A preferred apparatus according to the invention comprises a flat plate support surface and a feeder for delivering plates in series to the support surface. An array of nozzles N1 is spaced from the support surface and oriented to discharge developer liquid transversely onto a plate when on the support surface. A closed source vessel contains fresh developer liquid, and a supply line delivers developer liquid from the source vessel to the nozzle array. A pump or pressurized air moves the developer liquid from the supply line, to the nozzle array, whereby a pressurized flow of developer liquid can be selectively deposited from the nozzles N1 transversely at a section of the total surface area of the plate. The section addressed by each nozzle may be from e.g. 5 to 25% of the total surface area of the plate, more preferably from 10 to 20% of the plate.

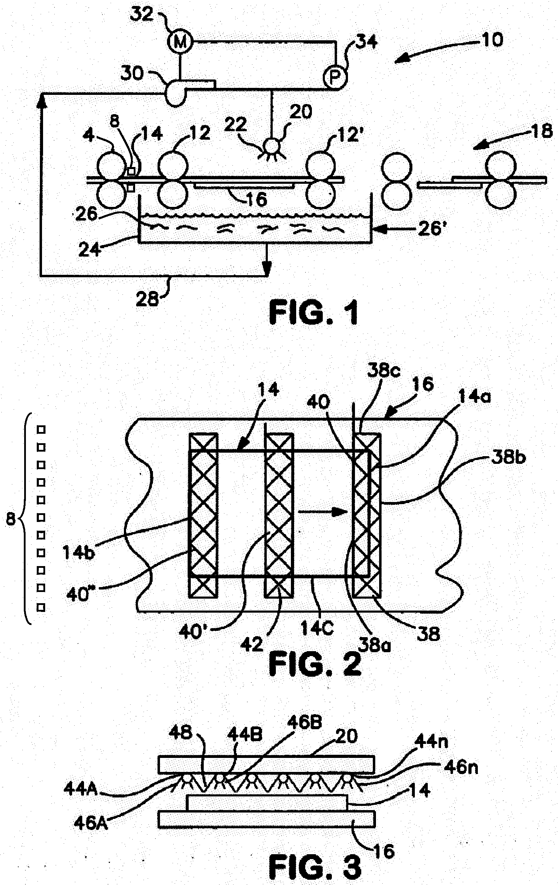

More specific embodiments of the invention will be described by reference to the figures. FIG. 1 is a schematic representation of a developer station 10 for depositing a pressurized spray of developer liquid on a plate. A feeder comprising a set of nip rolls 4 spaced apart less than the thickness of the plate delivers an imaged plate 14 to a flat platen or bed 16. - An array of optical cells 8 detect the plate when it is conveyed from the feeder to a set of nip rolls 12, 12'. Typically, other steps such as drying 18 can be performed after the plate 14 is passed on to another set of transport rolls. A spray bar 20 delivers a dynamic spray flow 22 of developer liquid transversely onto successive target areas of the plate 14 as the plate moves relative to the bar 20. Nip roll 12' (or a brush, squeegee or the like) located immediately downstream of the spray pattern, assures that a negligible layer of developer remains on the plate after a given portion of the plate has been developed by and has emerged from the spray pattern. Spray bar 20 is controlled by the signal detected by optical cells 8, which is passed on to the spray bar via circuitry (not shown) which ensures that only the nozzles N1 which are positioned within the width of the plate are actuated and substantially no developer is sprayed outside the plate area. This selective deposition of developer by spray bar 20 also takes place in the length direction of the plate, i.e. the nozzles of spray bar 20 are not activated immediately when the plate is detected by optical cells 8, but some time thereafter; the time delay is dependent on the speed at which the plate is conveyed through the apparatus, but chosen sufficiently long so that no developer is sprayed until the plate leading edge reaches the target area of the nozzles.

Spent and overflow developer liquid is captured in a sump 24 below support surface 16. The sump contains the source volume 26 of developer liquid. A source supply line 28 directly connects the sump with pump 30. The developer supplied via line 28 to pump 30, can be considered "fresh" in the sense that it has the required strength to support the chemical reaction associated with dissolution of the relatively soluble regions of the coating. Pump 30 is operated by motor 32, for delivering high pressure developer liquid to the spray bar 20. A pressure sensor 34 can be connected to the pump output for maintaining the pressure within a tight band around a desired set point. Preferably, the source can be supplemented by a flow 26' of replenishing chemical to compensate for drag out and chemical depletion due to the dissolution reactions with the coating.

FIGS. 2 and 3 illustrate a technique for depositing the developer liquid onto the plate in accordance with the present invention. The plate 14 has four edges, more specifically a front end 14a, back end 14b, and sides 14c, defining a plate area on the support surface 16. The support surface is flat, so the plate 14 is likewise flat as the plate is transported. As the plate approaches the spray bar 20, the front end enters the spray pattern 38, which is essentially rectangular with front impact line 38a, back impact line 38b and side impact lines 38c. As the plate enters the spray pattern 38, a plate target area 40 is flooded with developer liquid. The spray pattern preferably has a greater width across sides 38c, than the width of the plate across sides 14c, resulting in a slight overlap 42 onto the support surface 16. The target area on the plate 14 flooded by the spray, moves across the plate at a constant speed, as the plate is transported under the spray bar 20. Thus, successively overlapping target areas of the plate are subjected to a spray of fresh developer liquid. In embodiments according to the present invention not shown in the figures, the plate is moved stepwise through the apparatus so that slightly overlapping spray patterns are consecutively applied to the plate and the volume applied by each spray can be adjusted in accordance with the average dot coverage on the section of the image that corresponds with the nozzle target area. In embodiments with (a) shuttling nozzle(s), a similar stepwise application of consecutive sprays can also be used in the width direction of the plate.

The position of the spray pattern and thus target areas at three different and non-contiguous moments in time, are shown schematically at 40, 40', and 40" in FIG. 2. Preferably, the spray pattern is directed at a forward angle, e.g., 20 to 45 degrees, so that the momentum of the spray at the plate surface pushes the applied developer liquid toward the front of the plate, away from areas of the plate that have not yet reached the spray pattern. In the preferred embodiment, the spray pattern impinges on only a portion of the plate, preferably less than 25% of the total area of the plate. Most favorably, the pattern impinges a target area that is less than 20% of the total area of the plate.

FIG. 3 shows that spray bar 20 has a multiplicity of spaced nozzles 44a, 44b, ... , 44n, each of which produces a spray stream 46a, 46b, ... , 46n that may optionally overlap as shown at 48. The spray streams can be tuned with respect to direction, shape, and overlap, whereby the impact of the overall spray pattern on the target area 40 of the plate, is substantially uniform with respect to the volume of developer liquid impingement per unit area of the target surface per unit time, and surface turbulence. Although the plate target area preferably experiences a continuous turbulent flooding, the spray can also be applied in consecutive pulses.

The spray can be adjusted to provide sufficient volume and pressure to push spent developer liquid off the target area and thereby maintain fresh developer liquid in contact with the coating throughout the target area. Dissolution of the soluble coating regions is achieved quickly and uniformly, by a flooding of the line of impingement of the developer liquid (e.g., at 38a) with the newly presented coating arriving on the surface 16, such that the developer liquid overlaps with turbulence at the line of impingement to the extent that the developer liquid is constantly displaced, and replaced with fresh developer liquid.

It is not necessary that the impact of the dynamic flow be so great as to physically dislodge partially dissolved coating material from the substrate or neighboring coating material that has not yet experienced any dissolution. The dynamic aspect of the flooding requires only that the flow have sufficient momentum to push away depleted solution and prevent a boundary layer from forming during the development dwell time. However, it is within the scope of the invention that the dynamic flow is at such high velocity that some physical dislodging of coating material occurs.

To reduce degradation of the developer liquid through surface reaction with carbon dioxide in the ambient air, a hood or cover can be positioned over the sump 24, with flaps or the like at the feed and discharge ends, and gaskets along the sides where the hood rests on the frame of the developer station. Alternatively, the sump could merely function as a funneling device, with the bulk of the overall developer volume contained in a closed source vessel, which in turn has a fluid line corresponding to line 28 in FIG. 1, for delivery to the pressurizing device. Replenishing developer can be added to the sump or to the vessel.

Many alternative configurations of the apparatus that is shown in the figures, are within the scope of the present invention. The above described spray nozzle(s) N1 can be substituted by one ore more valve jet nozzle(s) or needles which may deposit developer at a higher resolution than conventional spray nozzles. The above described spray bar can be replaced by a single spray or valve jet nozzle N1 which shuttles across the width of the plate, Also an array of spray, valve jet or inkjet nozzles N1, preferably aligned along the length direction of the plate, i.e. parallel to the path traveled by the plate, may shuttle over the width of the plate. A fixed array or shuttling array may comprise a plurality of spray, valve jet or inkjet nozzles N1 which are arranged as a matrix, or staggered in a zig-zag line.

The above described optical detectors 8 can be replaced by simple mechanical switches which are triggered by the weight of the plate as it passes over the switches. Alternatively, information about the plate size can be communicated electronically from the plate setter or the workflow software used for exposing the plate to a digital controller which is configured or programmed to selectively actuate the nozzles that deposit developer inside the plate area without applying unnecessary developer outside the plate

Especially when high-resolution nozzles N1, i.e. nozzles with a very small target area on the plate such as the nozzles of an inkjet head, are used, more intelligence can be built into the apparatus by supplying image data from the platesetter or the workflow software to the digital controller of the apparatus of the present invention. Image-controlled development can be achieved in the apparatus of the present invention by a digital controller wherein the average dot coverage at the target area of each nozzle, which is a section of the image, is calculated and which adjusts the volume of developer deposited on that target area in accordance with said average dot coverage. In such embodiment, no developer is deposited on "full-black" sections of the image, i.e. sections which consist entirely of printing areas, and a sufficient amount of developer is deposited on the gray and white sections of the image, wherein said amount is made proportional to the average dot coverage of said gray and white sections.

Ink jet heads which are suitable for use as nozzles N1 in the present invention can be of any type, but preferably of the drop-on-demand type such as piezoelectric or thermal inkjet heads. More details about suitable inkjet equipment can be found in e.g. the book "Digital printing of textiles", Chapter 3, first published in 2006 by Woodhead Publishing Limited, Cambridge, England. Besides inkjet heads, also automatically controlled spray nozzles can be used for selective and image-controlled deposition of developer. Such systems are available from Spraying Systems Co. (Wheaton, Illinois, USA) under the trade name AutoJet Spray Controllers and Systems, wherein spray variables are monitored and adjusted by the onboard spray application software. Also timing control and varying flow rate by pulse width modulation of the nozzles is easily achieved by such systems.

Although the developed plate can be gummed conventionally, e.g. by immersion of the plate in a gum solution or by uniform spraying of a gum solution onto the plate, a reduction of the gum consumption can be achieved by using a similar type of equipment and methods as discussed above for the development section. So all references to nozzles N1 above may equally apply to the nozzles N2 for depositing gum on the plate in accordance with the plate area or even with the image data of the plate, as explained above.

### Lithographic printing plate precursor

The apparatus and method of the present invention can be used for developing any type of lithographic plate. The image forming coating and the lithographic substrate of typical plate precursors have been extensively described in the patent literature.

Negative working plates typically form an image by light- or heat-induced chemical crosslinking or polymerisation of a photopolymer coating or by physical insolubilisation due to heat-induced coalescence, fusing or melting of thermoplastic polymer particles. Specially designed negative plates allow processing without hazardous developer, i.e. of high pH or containing a large amount of organic solvents, e.g. by using gums or a fountain solution of neutral or low pH. More details about the composition of and methods of making negative working plate precursors are described in e.g. US2009/0197206, EP2153279A, WO2006/048443, EP1349006A, EP1614538A, EP0931647A, WO2002/21215 and EP1817166A.

In positive working plates, the higher dissolution of non-printing areas is typically due to a kinetic differentiation of the dissolution process : the exposed areas dissolve more quickly in the developer than the non-exposed areas, so that a lithograpic image is obtained after a typical development time of 15 to 30 seconds. When a typical positive plate is treated with a developer for several minutes, both the exposed and the non-exposed areas dissolve in the developer and no image is formed. The apparatus and method of the present invention are especially suited for the development of positive plates.

More details about the composition of and methods of making positive working plate precursors are described in e.g. US2009/0197206, EP823327A, WO97/39894, EP864420A, WO99/63407, EP1826001A, EP901902A, EP909657A and EP1159133A.

### Developer

In one embodiment of the methods according to the present invention, solvent-based or alkaline developers may be used. Solvent based developers have mainly been used to develop negative-working, while positive-working plate precursors typically require a highly alkaline developer. Unless otherwise indicated, the amounts of developer ingredients given herein refer to the ready-to-use developer, which may be obtained by diluting a more concentrated solution that is supplied by the manufacturer.

Suitable alkaline developers for positive plates have been described in US2005/0162505. An alkaline developer is an aqueous solution which has a pH of at least 11, more typically at least 12, preferably from 12 to 14. Preferred high pH developers comprise at least one alkali metal silicate, such as lithium silicate, sodium silicate, and/or potassium silicate. Sodium silicate and potassium silicate are preferred, and potassium silicate is most preferred. A mixture of alkali metal silicates may be used if desired. Especially preferred high pH developers comprise an alkali metal silicate having a SiO₂ to M₂O weight ratio of at least of at least 0.3, in which M is the alkali metal. Preferably, the ratio is from 0.3 to 1.2. More preferably, it is from 0.6 to 1.1, and most preferably, it is from 0.7 to 1.0. The amount of alkali metal silicate in the high pH developer is typically at least 20 g of SiO₂ per 1000 g of developer (that is, at least 2 wt.%) and preferably from 20 g to 80 g of SiO₂ per 1000 g of developer (2-8 wt.%). More preferably, it is 40 g to 65 g of SiO₂ per 1000 g of developer (4-6.5 wt.%).

In addition to the alkali metal silicate, alkalinity can be provided by a suitable concentration of any suitable base, such as, for example, ammonium hydroxide, sodium hydroxide, lithium hydroxide, and/or potassium hydroxide. A preferred base is potassium hydroxide. Optional components of high pH developers are anionic, nonionic and amphoteric surfactants (up to 3% on the total composition weight), biocides (antimicrobial and/or antifungal agents), antifoaming agents or chelating agents (such as alkali gluconates), and thickening agents (water soluble or water dispersible polyhydroxy compounds such as glycerin or polyethylene glycol). However, these developers preferably do not contain organic solvents.

Solvent-based alkaline developers typically have a pH below 10.5, especially below 10.2 (measured at 25°C). Solvent-based developers comprise water and an organic solvent or a mixture of organic solvents. They are typically free of silicates, alkali metal hydroxides, and mixtures of silicates and alkali metal hydroxides. The developer is preferably a single phase. Consequently, the organic solvent or mixture of organic solvents is preferably either miscible with water or sufficiently soluble in the developer that phase separation does not occur. Optional components include anionic, nonionic and amphoteric surfactants (up to 3% on the total composition weight), and biocides (antimicrobial and/or antifungal agents).

The following solvents and mixtures thereof are suitable for use in solvent-based developers: the reaction products of phenol with ethylene oxide (phenol ethoxylates) and with propylene oxide (phenol propoxylates), such as ethylene glycol phenyl ether (phenoxyethanol); benzyl alcohol; esters of ethylene glycol and of propylene glycol with acids having six or fewer carbon atoms, and ethers of ethylene glycol, diethylene glycol, and propylene glycol with alkyl groups having six or fewer carbon atoms, such as 2-ethoxyethanol, 2-(2-ethoxy)ethoxyethanol, and 2-butoxyethanol. A developer that comprises phenoxyethanol is preferred. The developer typically comprises 0.5 wt % to 15 wt %, preferably 3 wt % to 5 wt %, of the organic solvent or solvents, based on the weight of the developer.

A suitable alternative developer for processing positive plates comprises a non-reducing sugar and a base, as described in EP1403716A. The term "nonreducing sugar" means a saccharide which is free of free aldehyde or ketone group and thus is not reducing, e.g. trehalose type oligosaccharides, glycosides and sugar alcohols obtained by hydrogenating and reducing saccharides. Examples of the trehalose type oligosaccharides include saccharose, and trehalose. Examples of the glycosides include alkyl glycoside, phenol glycoside, and mustard oil glycoside. Examples of the sugar alcohols include D, L-arabitol, ribitol, xylitol, D,L-sorbitol, D,L-mannitol, D,L-iditol, D,L-talitol, dulcitol, and arodulicitol. Further, maltitol obtained by the hydrogenation of disaccharide or reduced material (reduced starch sirup) obtained by the hydrogenation of oligosaccharide may be used. Preferred among these nonreducing sugars are sugar alcohols and saccharose. Even more desirable among these nonreducing sugars are D-sorbitol, saccharose, and reduced starch sirup because they have buffer action within a proper pH range.

These nonreducing sugars may be used alone or in combination of two or more thereof. The proportion of these nonreducing sugars in the developer is preferably from 0.1 to 30% by weight, more preferably from 1 to 20% by weight.

The aforementioned nonreducing sugar may be used in combination with an alkaline agent as a base, properly selected from the group consisting of known materials such as inorganic alkaline agents, e.g. sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium hydrogencarbonate, potassium hydrogencarbonate, ammonium hydrogencarbonate, sodium borate, potassium borate and ammonium borate, potassium citrate, tripotassium citrate, and sodium citrate.

Further preferred examples of alkaline agents include organic alkaline agents such as menomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

These alkaline agents may be used singly or in combination of two or more thereof. Preferred among these alkaline agents are sodium hydroxide, potassium hydroxide, trisodium phosphate, tripotassium phosphate, sodium carbonate and potassium carbonate.

Another alternative silicate-free and sugar-free alkaline aqueous developer composition, as described in US2012/0129033, has a pH of at least 12 and comprises (a) a hydroxide, (b) a metal cation M2' selected from barium, calcium, strontium, and zinc cations, (c) a chelating agent for the metal cation M+ and (d) an alkali metal salt different than all of a, b, and c above.

### Gum developer

Preferred developers comprise a gum and are capable of developing and gumming the plate in a single step. Such gum developers have been described in EP1342568A and WO2005/111727. A gum is typically an aqueous liquid which comprises one or more surface protective compounds that are capable of protecting the lithographic image of a printing plate against contamination, oxidation or damaging. Suitable examples of such compounds are film-forming hydrophilic polymers or surfactants. The layer that remains on the plate after treatment with the gum solution and drying preferably comprises between 0.1 and 20 g/m² of the surface protective compound. This layer typically remains on the plate until the plate is mounted on the press and is removed by the ink and/or fountain when the press run has been started.

Unless otherwise indicated, the amounts of gum ingredients given herein refer to the ready-to-use gum developer, which may be obtained by diluting a more concentrated solution that is supplied by the manufacturer.

Preferred polymers for use as protective compound in the gum solution are gum arabic, pullulan, cellulose derivatives such as carboxymethylcellulose, carboxyethylcellulose or methylcellulose, (cyclo)dextrin, poly(vinyl alcohol), poly(vinyl pyrrolidone), polysaccharide, homo- and copolymers of acrylic acid, methacrylic acid or acrylamide, a copolymer of vinyl methyl ether and maleic anhydride, a copolymer of vinyl acetate and maleic anhydride or a copolymer of styrene and maleic anhydride. Highly preferred polymers are homo- or copolymers of monomers containing carboxylic, sulfonic or phosphonic groups or the salts thereof, e.g. (meth)acrylic acid, vinyl acetate, styrene sulfonic acid, vinyl sulfonic acid, vinyl phosphonic acid or acrylamidopropane sulfonic acid.

Examples of surfactants for use as surface protective agent include anionic or nonionic surfactants. The gum solution may also comprise one or more of the above hydrophilic polymers as surface protective agent and, in addition, one or more surfactants to improve the surface properties of the coated layer. The surface tension of the gum solution is preferably from 40 to 50 mN/m.

Examples of the anionic surfactant include aliphates, abietates, hydroxyalkanesulfonates, alkanesulfonates, dialkylsulfosuccinates, straight-chain alkylbenzenesulfonates, branched alkylbenzenesulfonates, alkylnaphthalenesulfonates, alkylphenoxypolyoxyethylenepropylsulfonates, salts of polyoxyethylene alkylsulfophenyl ethers, sodium N-methyl-N-oleyltaurates, monoamide disodium N-alkylsulfosuccinates, petroleum sulfonates, sulfated castor oil, sulfated tallow oil, salts of sulfuric esters of aliphatic alkylesters, salts of alkylsulfuric esters, sulfuric esters of polyoxyethylenealkylethers, salts of sulfuric esters of aliphatic monoglycerides, salts of sulfuric esters of polyoxyethylenealkylphenylethers, salts of sulfuric esters of polyoxyethylenestyrylphenylethers, salts of alkylphosphoric esters, salts of phosphoric esters of polyox-yethylenealkylethers, salts of phosphoric esters of polyoxyethylenealkylphenylethers, partially saponified compounds of styrenemaleic anhydride copolymers, partially saponified compounds of olefin-maleic anhydride copolymers, and naphthalenesulfonateformalin condensates. Particularly preferred among these anionic surfactants are dialkylsulfosuccinates, salts of alkylsulfuric esters and alkylnaphthalenesulfonates.

Specific examples of suitable anionic surfactants include sodium dodecylphenoxybenzene disulfonate, the sodium salt of alkylated naphthalenesulfonate, disodium methylene-dinaphtalene-disulfonate, sodium dodecyl-benzenesulfonate, sulfonated alkyl-diphenyloxide, ammonium or potassium perfluoroalkylsulfonate and sodium dioctyl-sulfosuccinate.

Suitable examples of the nonionic surfactants include polyoxyethylene alkyl ethers, polyoxyethylene alkyl phenyl ethers, polyoxyethylene polystyryl phenyl ethers, polyoxyethylene polyoxypropylene alkyl ethers, polyoxyethylene polyoxypropylene block polymers, partial esters of glycerinaliphatic acids, partial esters of sorbitanaliphatic acid, partial esters of pentaerythritolaliphatic acid, propyleneglycolmonoaliphatic esters, partial esters of sucrosealiphatic acids, partial esters of polyoxyethylenesorbitanaliphatic acid, partial esters of polyoxyethylenesorbitolaliphatic acids, polyethyleneglycolaliphatic esters, partial esters of poly-glycerinaliphatic acids, polyoxyethylenated castor oils, partial esters of polyoxyethyleneglycerinaliphatic acids, aliphatic diethanolamides, N,N-bis-2-hydroxyalkylamines, polyoxyethylene alkylamines, triethanolaminealiphatic esters, and trialkylamine oxides. Particularly preferred among these nonionic surfactants are polyoxyethylene alkylphenyl ethers and poloxyethylene-polyoxypropylene block polymers. Further, fluorinic and siliconic anionic and nonionic surfactants may be similarly used.

Two or more of the above surfactants may be used in combination in the gum. For example, a combination of two or more different anionic surfactants or a combination of an anionic surfactant and a nonionic surfactant may be preferred. The amount of such a surfactant is not specifically limited but is preferably from 0.01 to 20 wt.%.

The gum solution has preferably a pH from 3 to 8, more preferably from 6 to 8. The pH of the gum solution is usually adjusted with a mineral acid, an organic acid or an inorganic salt in an amount of from 0.01 to 2 wt.%. Examples of the mineral acids include nitric acid, sulfuric acid, phosphoric acid and metaphosphoric acid. Especially organic acids are used as pH control agents and as desensitizing agents. Examples of the organic acids include carboxylic acids, sulfonic acids, phosphonic acids or salts thereof, e.g. succinates, phosphates, phosphonates, sulfates and sulfonates. Specific examples of the organic acid include citric acid, acetic acid, oxalic acid, malonic acid, p-toluenesulfonic acid, tartaric acid, malic acid, lactic acid, levulinic acid, phytic acid and organic phosphonic acid. Examples of the inorganic salt include magnesium nitrate, monobasic sodium phosphate, dibasic sodium phosphate, nickel sulfate, sodium hexametaphosphate and sodium tripolyphosphate. Other inorganic salts can be used as corrosion inhibiting agents, e.g. magnesium sulfate or zinc nitrate. The mineral acid, organic acid or inorganic salt may be used singly or in combination with one or more thereof.

Besides the foregoing components, a wetting agent such as ethylene glycol, propylene glycol, triethylene glycol, butylene glycol, hexylene glycol, diethylene glycol, dipropylene glycol, glycerin, trimethylol propane and diglycerin may also be present in the gum solution. The wetting agent may be used singly or in combination with one or more thereof. In general, the foregoing wetting agent is preferably used in an amount of from 1 to 25 wt.%.

Further, a chelate compound may be present in the gum solution. Calcium ion and other impurities contained in the diluting water can have adverse effects on printing and thus cause the contamination of printed matter. This problem can be eliminated by adding a chelate compound to the diluting water. Preferred examples of such a chelate compound include organic phosphonic acids or phosphonoalkanetricarboxylic acids. Specific examples are potassium or sodium salts of ethylenediaminetetraacetic acid, diethylenetriaminepentaacetic acid, triethylenetetraminehexaacetic acid, hydroxyethylethylenediaminetriacetic acid, nitrilotriacetic acid, 1-hydroxyethane-1,1-diphosphonic acid and aminotri(methylenephosphonic acid). Besides these sodium or potassium salts of these chelating agents, organic amine salts are useful. The preferred amount of such a chelating agent to be added is from 0.001 to 1.0 wt.% relative to the gum solution in diluted form.

Further, an antiseptic and an anti-foaming agent may be present in the gum solution. Examples of such an antiseptic include phenol, derivatives thereof, formalin, imidazole derivatives, sodium dehydroacetate, 4-isothiazoline-3-one derivatives, benzoisothiazoline-3-one, benztriazole derivatives, amidineguanidine derivatives, quaternary ammonium salts, pyridine derivatives, quinoline derivatives, guanidine derivatives, diazine, triazole derivatives, oxazole and oxazine derivatives. The preferred amount of such an antiseptic to be added is such that it can exert a stable effect on bacteria, fungi, yeast or the like. Though depending on the kind of bacteria, fungi and yeast, it is preferably from 0.01 to 4 wt.% relative to the gum solution in diluted form. Further, preferably, two or more antiseptics may be used in combination to exert an aseptic effect on various fungi and bacteria. The anti-foaming agent is preferably silicone anti-foaming agents. Among these anti-foaming agents, either an emulsion dispersion type or solubilized type anti-foaming agent may be used. The proper amount of such an anti-foaming agent to be added is from 0.001 to 1.0 wt.% relative to the gum solution in diluted form.

Besides the foregoing components, an ink receptivity agent may be present in the gum solution if desired. Examples of such an ink receptivity agent include turpentine oil, xylene, toluene, low heptane, solvent naphtha, kerosine, mineral spirit, hydrocarbons such as petroleum fraction having a boiling point of 120°C to 250°C, diester phthalates (e.g., dibutyl phthalate, diheptyl phthalate, di-n-octyl phthalate, di(2-ethylhexyl) phthalate, dinonyl phthalate, didecyl phthalate, dilauryl phthalate, butylbenzyl phthalate), aliphatic dibasic esters (e.g., dioctyl adipate, butylglycol adipate, dioctyl azelate, dibutyl sebacate, di(2-ethylhexyl) sebacate dioctyl sebacate), epoxidated triglycerides (e.g., epoxy soyabean oil), ester phosphates (e.g., tricresyl phosphate, trioctyl phosphate, trischloroethyl phosphate) and plasticizers having a solidification point of 15°C or less and a boiling point of 300°C or more at one atmospheric pressure such as esters of benzoates (e.g., benzyl benzoate). Examples of other solvents which can be used in combination with these solvents include ketones (e.g., cyclohexanone), halogenated hydrocarbons (e.g., ethylene dichloride), ethylene glycol ethers (e.g., ethylene glycol monomethyl ether, ethylene glycol monophenyl ether, ethylene glycol monobutyl ether), aliphatic acids (e.g., caproic acid, enathic acid, caprylic acid, pelargonic acid, capric acid, undecylic acid, lauric acid, tridecylic acid, myristic acid, pentadecylic acid, palmitic acid, heptadecylic acid, stearic acid, nonadecanic acid, arachic acid, behenic acid, lignoceric acid, cerotic acid, heptacosanoic acid, montanic acid, melissic acid, lacceric acid, isovaleric acid) and unsaturated aliphatic acids (e.g., acrylic acid, crotonic acid, isocrotonic acid, undecyclic acid, oleic acid, elaidic acid, cetoleic acid, erucic acid, butecidic acid, sorbic acid, linoleic acid, linolenic acid, arachidonic acid, propiolic acid, stearolic acid, clupanodonic acid, tariric acid, licanic acid). Preferably, it is an aliphatic acid which is liquid at a temperature of 50°C, more preferably has from 5 to 25 carbon atoms, most preferably has from 8 to 21 carbon atoms. The ink receptivity agent may be used singly or in combination with one or more thereof. The ink receptivity agent is preferably used in an amount of from 0.01 to 10 wt.%, more preferably from 0.05 to 5 wt.%. The foregoing ink receptivity agent may be present as an oil-in-water emulsion or may be solubilized with the aid of a solubilizing agent.

The viscosity of the gum solution can be adjusted to a value of e.g. between 1.7 and 5 cP, by adding viscosity increasing compounds, such as poly(ethylene oxide), e.g. having a molecular weight between 10⁵ and 10⁷. Such compounds can be present in a concentration of 0.01 to 10 g/l.

A baking gum has a similar composition as described above, with the additional preference towards compounds that do not evaporate at the usual bake temperatures. Specific examples of suitable baking gum solutions are described in e.g. EP-A 222 297, EP-A 1 025 992, DE-A 2 626 473 and US 4,786,581.

## Claims

1. An apparatus for processing a lithographic printing plate which comprises a latent image consisting of printing areas and non-printing areas, the apparatus comprising :
- plate transport means adapted to convey the plate through the apparatus along a path, the plate having edges which define a plate area and a plate width, wherein the plate width is defined as the edge-to-edge distance of the plate along the direction perpendicular to the path;
- plate detection means adapted to locate the plate in the apparatus and adapted to determine the plate width;
- one or more nozzle(s) N1 adapted to deposite developer on the plate, wherein said nozzle(s) N1 are arranged to shuttle over the plate or are arranged as a fixed array that spans at least the width of the plate;
**characterized in that** said plate detection means are coupled to the nozzles N1 by means for selectively actuating the nozzles N1 that are positioned to deposit developer across the plate area; and that said plate detection means include means adapted to provide input about dot coverage data of the image of the plate from a platesetter or from a pre-press workflow system to a controller which is coupled to the nozzles N1 and which is configured for selectively actuating the nozzles N1 that are positioned to deposit developer on the non-printing areas of the image.

2. The apparatus according to claim 1 wherein the plate detection means further comprise an array of optical or mechanical detectors for detecting the plate as it is conveyed along the path.

3. The apparatus according to claims 1 or 2 wherein the plate detection means comprise a mechanical device for pushing one of the plate edges against a guide bar, combined with means adapted to detect the edge of the plate opposite to said guide bar.

4. The apparatus according to any of the preceding claims wherein the plate detection means include means adapted to provide input about dot coverage data of the image of the plate from a platesetter or from a pre-press workflow system to a controller which is coupled to the nozzles N1 and which is configured for selectively actuating the nozzles N1 that are positioned to deposit developer on the non-printing areas of the image.

5. An apparatus according to claim 4 wherein the controller comprises means adapted to adjust the amount of developer, which is deposited by each nozzle on a section of the image, in accordance with the average dot coverage of said section of the image.

6. The apparatus according to claim 5 which further comprises one or more nozzle(s) N2 for selectively depositing a gum solution on the plate.

7. The apparatus according to any of the preceding claims wherein the nozzles N1 and/or N2 are spray nozzles.

8. The apparatus according to any of the preceding claims wherein the nozzles N1 and/or N2 are valve-jet or ink-jet nozzles.

9. The apparatus according to any of the preceding claims wherein the nozzles N1 and/or N2 are needles.

10. A method for developing a lithographic printing plate which comprises a latent image consisting of printing areas and non-printing areas, said method comprising the steps of feeding the plate to an apparatus as defined in any of the claims 1 to 9 and developing the image by selectively actuating the nozzles N1, thereby depositing developer across the plate area.

11. The method according to claim 10 wherein an apparatus as defined in claim 6 is used, further comprising the step of gumming the plate by selectively actuating the nozzles N2, thereby depositing a gum solution across the plate area.

12. The method according to claim 10 or 11 wherein the amount of developer and/or the amount of gum, which is or are deposited on a section of the image, is adjusted in accordance with the average dot coverage of that section of the image.

13. The method according to any of claims 10 to 12, wherein the lithographic printing plate is a positive working plate.

14. The method according to any of claims 10 to 13, wherein the lithographic printing plate is a heat-sensitive plate.

## Patentansprüche

1. Ein Apparat zur Verarbeitung einer lithografischen Druckplatte, die ein aus druckenden Bereichen und nicht-druckenden Bereichen bestehendes latentes Bild umfasst, wobei der Apparat Folgendes umfasst:
- Plattenfördermittel, die so angepasst sind, dass sie die Platte entlang einer Strecke durch den Apparat transportieren, wobei die Platte Ränder, die einen Plattenbereich und eine Plattenbreite definieren, aufweist, wobei die Plattenbreite als der Rand-zu-Rand-Abstand der Platte in die senkrecht auf die Strecke verlaufende Richtung definiert wird,
- Plattendetektionsmittel, die so angepasst sind, dass sie die Platte im Apparat lokalisieren und die Plattenbreite bestimmen,
- eine oder mehrere Düsen N1, die so angepasst sind, dass sie Entwickler auf die Platte absetzen, wobei die Düse(n) N1 so angeordnet ist (sind), dass sie sich pendelnd über die Platte hinweg bewegt (bewegen), oder als eine sich mindestens über die Breite der Platte erstreckende feststehende Matrix angeordnet ist (sind),
**dadurch gekennzeichnet, dass** die Plattendetektionsmittel mittels Mitteln, welche die Düsen N1, die so positioniert sind, dass sie Entwickler auf den Plattenbereich absetzen, selektiv betätigen, mit den Düsen N1 gekoppelt sind und dass die Plattendetektionsmittel Mittel umfassen, die so angepasst sind, dass sie Input über die Punktdeckungsdaten des Plattenbildes von einem Plattenbelichter oder einem Prepress-Workflowsystem zu einem mit den Düsen N1 gekoppelten Steuergerät übermitteln, wobei das Steuergerät so konfiguriert ist, dass sie die Düsen N1, die so positioniert sind, dass sie Entwickler auf die nicht-druckenden Bereiche des Bildes absetzen, selektiv betätigt.

2. Der Apparat nach Anspruch 1, wobei die Plattendetektionsmittel ferner eine Matrix optischer oder mechanischer Detektoren, welche die Platte während seines Transports entlang der Strecke detektieren, umfassen.

3. Der Apparat nach den Ansprüchen 1 oder 2, wobei die Plattendetektionsmittel eine mechanische Vorrichtung umfassen, die einen der Plattenränder gegen eine Führungsstange drückt, kombiniert mit Mitteln, die so angepasst sind, dass sie den der Führungsstange gegenüberliegenden Rand der Platte detektieren.

4. Der Apparat nach einem der vorstehenden Ansprüche, wobei die Plattendetektionsmittel Mittel umfassen, die so angepasst sind, dass sie Input über die Punktdeckungsdaten des Plattenbildes von einem Plattenbelichter oder einem Prepress-Workflowsystem zu einem mit den Düsen N1 gekoppelten Steuergerät übermitteln, wobei das Steuergerät so konfiguriert ist, dass sie die Düsen N1, die so positioniert sind, dass sie Entwickler auf die nicht-druckenden Bereiche des Bildes absetzen, selektiv betätigt.

5. Der Apparat nach Anspruch 4, wobei das Steuergerät Mittel umfasst, die so angepasst sind, dass sie die Entwicklermenge, die durch jede Düse auf einen Teil des Bildes abgesetzt wird, in Übereinstemmung mit der mittleren Punktdeckung des genannten Bildteils regeln.

6. Der Apparat nach Anspruch 5, der ferner eine oder mehrere Düsen N2, die eine Gummierlösung selektiv auf die Platte absetzen, umfasst.

7. Der Apparat nach einem der vorstehenden Ansprüche, wobei die Düsen N1 und/oder N2 Spritzdüsen sind.

8. Der Apparat nach einem der vorstehenden Ansprüche, wobei die Düsen N1 und/oder N2 Valve-Jet-Düsen oder Tintenstrahldüsen sind.

9. Der Apparat nach einem der vorstehenden Ansprüche, wobei die Düsen N1 und/oder N2 Nadeln sind.

10. Ein Verfahren zur Entwicklung einer lithografischen Druckplatte, die ein aus druckenden Bereichen und nicht-druckenden Bereichen bestehendes latentes Bild umfasst, wobei das Verfahren die Schritte der Einführung der Platte in einen wie nach einem der Ansprüche 1 bis 9 definierten Apparat und der Entwicklung des Bildes durch selektives Betätigen der Düsen N1, wobei Entwickler über den Plattenbereich hinweg abgesetzt wird, umfasst.

11. Das Verfahren nach Anspruch 10, in dem ein wie nach Anspruch 6 definierter Apparat verwendet wird, ferner umfassend den Schritt, in dem die Platte durch selektives Betätigen der Düsen N2, wobei über den Plattenbereich hinweg eine Gummierlösung abgesetzt wird, gummiert wird.

12. Das Verfahren nach Anspruch 10 oder 11, wobei die Entwicklermenge und/oder die Menge Gummierlösung, die auf einen Teil des Bildes abgesetzt wird (werden), in Übereinstemmung mit der mittleren Punktdeckung des genannten Bildteils geregelt wird (werden).

13. Das Verfahren nach einem der Ansprüche 10 bis 12, wobei die lithografische Druckplatte eine positiv arbeitende Platte ist.

14. Das Verfahren nach einem der Ansprüche 10 bis 13, wobei die lithografische Druckplatte eine wärmeempfindliche Platte ist.

## Revendications

1. Appareil pour le traitement d'une plaque d'impression lithographique comprenant une image latente composée de zones imprimantes et de zones non imprimantes, ledit appareil comprenant:
- des moyens de transport de plaque adaptés de façon à transporter la plaque à travers l'appareil le long d'une trajectoire, ladite plaque présentant des bords définissant une zone de plaque et une largeur de plaque, ladite largeur de plaque étant définie comme la distance bord-à-bord de la plaque dans le sens perpendiculaire à la trajectoire,
- des moyens de détection de plaque adaptés de façon à localiser la plaque dans l'appareil et à déterminer la largeur de plaque,
- une ou plusieurs buses N1 adaptées de façon à déposer du révélateur sur la plaque, lesdites une ou plusieurs buses N1 étant disposées de façon à effectuer un mouvement de va-et-vient en travers de la plaque ou étant disposées comme une matrice fixe s'étendant au moins sur la largeur de la plaque,
**caractérisé en ce que** les moyens de détection de plaque sont couplés aux buses N1 par des moyens actionnant de façon sélective les buses N1 qui sont positionnées de façon à déposer du révélateur sur la zone de plaque, et que les moyens de détection de plaque comprennent des moyens adaptés de façon à transmettre des données d'entrée relatives aux données de couverture de point de l'image de la plaque à partir d'une unité d'exposition directe de plaque ou d'un système de flux de travail de prépresse à un contrôleur couplé aux buses N1 et étant configuré de façon à actionner de façon sélective les buses N1 qui sont positionnées de façon à déposer du révélateur sur les zones non imprimantes de l'image.

2. Appareil selon la revendication 1, **caractérisé en ce que** les moyens de détection de plaque comprennent en outre une matrice de détecteurs optiques ou mécaniques détectant la plaque lors de son transport le long de la trajectoire.

3. Appareil selon les revendications 1 ou 2, **caractérisé en ce que** les moyens de détection de plaque comprennent un dispositif mécanique pressant l'un des bords de plaque contre une barre de guidage, combinés à des moyens adaptés de façon à détecter le bord de plaque opposée à ladite barre de guidage.

4. Appareil selon l'une quelconque des revendications précédentes, **caractérisé en ce que** les moyens de détection de plaque comprennent des moyens adaptés de façon à transmettre des données d'entrée relatives aux données de couverture de point de l'image de la plaque à partir d'une unité d'exposition directe de plaque ou d'un système de flux de travail de prépresse à un contrôleur couplé aux buses N1 et étant configuré de façon à actionner de façon sélective les buses N1 qui sont positionnées de façon à déposer du révélateur sur les zones non imprimantes de l'image.

5. Appareil selon la revendication 4, **caractérisé en ce que** le contrôleur comprend des moyens adaptés de façon à régler la quantité de révélateur déposée par chaque buse sur une partie de l'image et ce conformément à la couverture de point moyenne de ladite partie de l'image.

6. Appareil selon la revendication 5, comprenant en outre une ou plusieurs buses N2 déposant de façon sélective une solution de gommage sur la plaque.

7. Appareil selon l'une quelconque des revendications précédentes, **caractérisé en ce que** les buses N1 et/ou N2 sont des buses de pulvérisation.

8. Appareil selon l'une quelconque des revendications précédentes, **caractérisé en ce que** les buses N1 et/ou N2 sont des buses du type Valve Jet ou des buses pour impression à jet d'encre.

9. Appareil selon l'une quelconque des revendications précédentes, **caractérisé en ce que** les buses N1 et/ou N2 sont des aiguilles.

10. Procédé pour le développement d'une plaque d'impression lithographique comprenant une image latente composée de zones imprimantes et de zones non imprimantes, ledit procédé comprenant les étapes consistant à introduire la plaque dans un appareil tel que défini selon l'une quelconque des revendications 1 à 9 et à développer l'image en actionnant de façon sélective les buses N1 déposant du révélateur sur la zone de plaque.

11. Procédé selon la revendication 10, dans lequel est utilisé un appareil tel que défini selon la revendication 6, comprenant en outre l'étape consistant à gommer la plaque en actionnant de façon sélective les buses N2 déposant une solution de gommage sur la zone de plaque.

12. Procédé selon la revendication 10 ou 11, **caractérisé en ce que** la quantité de révélateur et/ou la quantité de solution de gommage déposée(s) sur une partie de l'image est (sont) réglée(s) conformément à la couverture de point moyenne de ladite partie de l'image.

13. Procédé selon l'une quelconque des revendications 10 à 12, **caractérisé en ce que** la plaque d'impression lithographique est une plaque positive.

14. Procédé selon l'une quelconque des revendications 10 à 13, **caractérisé en ce que** la plaque d'impression lithographique est une plaque thermosensible.
